# FASCICULE DE BREVET EUROPEEN

(11) **EP 0 836 099 B1**
(45) Date de publication et mention de la délivrance du brevet: **29.09.2004**
(21) Numéro de dépôt: 97402379.8
(22) Date de dépôt: 09.10.1997
(51) Int. Cl.: G01R 1/22, B25B 9/00

(54) **Agencement d'ouverture d'une pince telle qu'une pince ampèremétrique**
Öffnungsanordnung für Zange insbesondere Strommesszange
Device for opening a clamp such as a current measuring clamp

(30) Priorité: 10.10.1996 FR 9612385
(43) Date de publication de la demande: 15.04.1998
(73) Titulaire: CHAUVIN ARNOUX, 75018 Paris (FR)
(72) Inventeur: Arnoux, Daniel, 75018 Paris (FR); Arnoux, Axel, 75018 Paris (FR); Genter, Claude, 75018 Paris (FR)
(74) Mandataire: Berger, Helmut

(56) Documents cités:
- DE-U- 8 813 678
- US-A- 2 708 592

## Description

L'invention concerne un agencement d'ouverture d'une pince telle qu'une pince ampèremétrique, du type comprenant une mâchoire de pince fixe portée par un levier fixe et une mâchoire de pince mobile portée par un levier monté pivotant sur le levier fixe, autour d'un axe solidaire de ce dernier, entre des positions de fermeture et d'ouverture de la pince, et un ressort de traction de rappel du levier pivotant dans la position de fermeture de la pince.

On connaît déjà des agencements d'ouverture de pince ampèremétrique, qui utilisent des ressorts de traction et de compression et où la force d'ouverture suit l'axe du ressort. Ces agencements présentent l'inconvénient majeur que la force d'ouverture de la pince croît quasi-linéairement avec l'angle d'ouverture, ce qui limite le confort d'utilisation, et que l'effort nécessaire à l'ouverture est important et croit au fur et à mesure de l'ouverture.

La présente invention a pour but de proposer un agencement d'ouverture de pince qui ne présente pas l'inconvénient susmentionné.

Pour atteindre ce but, dans l'agencement selon la revendication 1 le ressort est disposé entre un emplacement sur le levier fixe et un emplacement sur le levier pivotant, de façon que le ressort s'allonge lors du pivotement du levier de sa position de fermeture de pince dans sa position d'ouverture de pince et se rapproche de l'axe de pivotement des deux leviers si bien que l'augmentation de la force de rappel s'accompagne d'une réduction du bras de levier de cette force autour de l'axe de pivotement, l'axe du ressort de traction et l'axe de la force d'ouverture formant un angle sensiblement droit.

Par le document US 2 708 592 est connu un agencement de pince dans lequel le ressort s'allonge lors du pivotement du levier dans sa position d'ouverture de pince et se rapproche de l'axe de pivotement des deux leviers. Mais, cet agencement de pince est d'un type différent. Il est conçu pour permettre le levage d'objets et présente une configuration générale spécifique dans laquelle les leviers solidaires des mâchoires font partie d'un parallélogramme et l'organe d'actionnement est un autre levier constituant le prolongement d'un troisième côté de ce parallélogramme, l'axe de la force d'actionnement étant approximativement parallèle à l'axe du ressort. Par conséquent, ce document ne donne aucun enseignement pour la réalisation de l'invention.

L'invention sera mieux comprise et d'autres buts, caractéristiques, détails et avantages de celle-ci apparaîtront plus clairement au cours de la description explicative qui va suivre faite en référence aux dessins schématiques annexés donnés uniquement à titre d'exemple illustrant un mode de réalisation de l'invention et dans lesquels :
La figure 1 est une vue en perspective d'une pince ampèremétrique selon l'invention.
Les figures 2 et 3 sont des vues perpendiculaires au plan II-II de la pince ampèremétrique selon la figure 1 et montrant l'agencement d'ouverture de pince selon la présente invention, dans des positions respectivement de fermeture et d'ouverture de la pince.
La figure 4 montre un schéma expliquant le fonctionnement de l'invention.

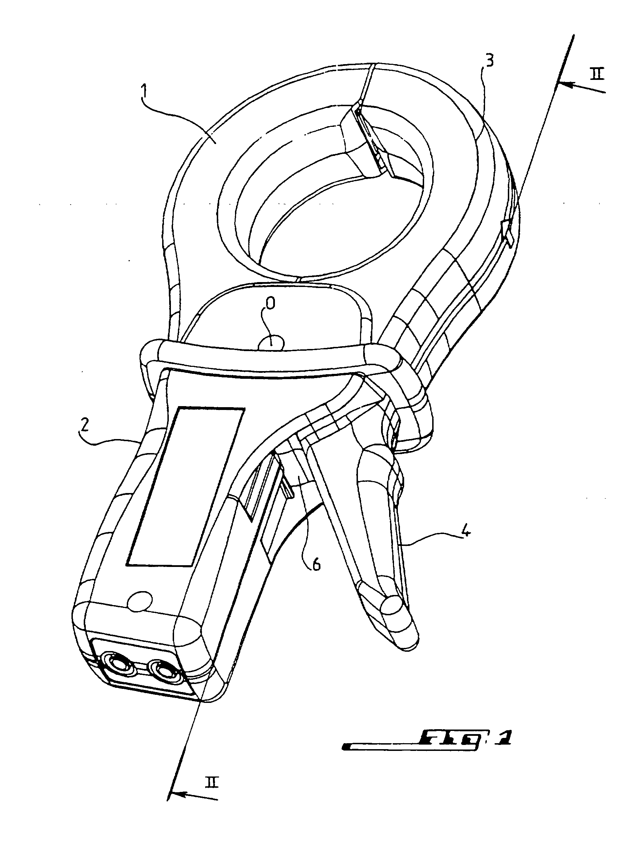

Comme on le voit sur les figures 1 à 3, la pince ampèremétrique pourvue de l'agencement d'ouverture selon l'invention comprend une mâchoire fixe 1 portée par un levier 2 fixe réalisé sous forme d'un boîtier destiné à loger le dispositif des circuits électriques de la pince, et une mâchoire mobile 3 portée par un levier 4 appelé gâchette et monté sur le levier de boîtier 2, pivotant autour d'un axe 0 supporté par le levier fixe 2.

Comme le montre les figures, aussi bien la partie fixe formée par la mâchoire 1 et le levier 2 que la partie mobile formée par la mâchoire 3 et la gâchette 4 est obtenue par assemblage de deux moitiés symétriques par rapport au plan médian longitudinal II-II, perpendiculaire à l'axe de pivotement O.

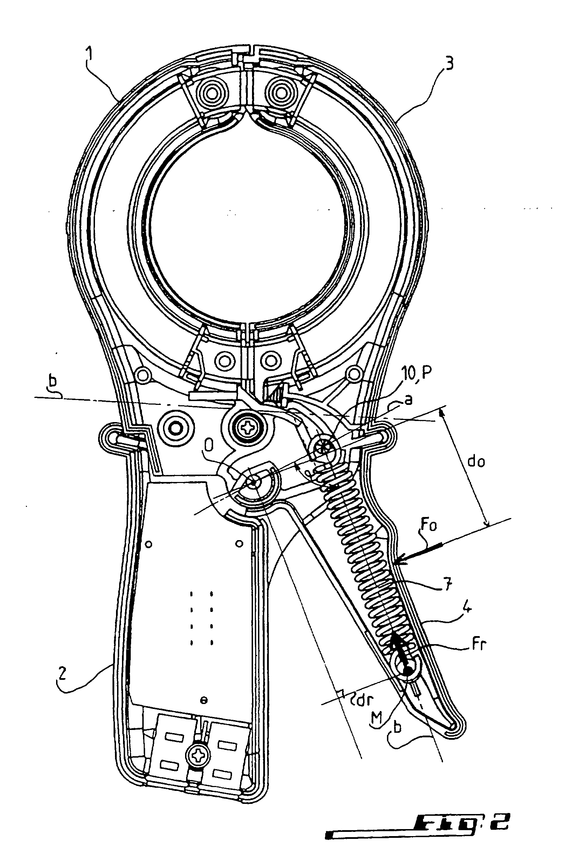

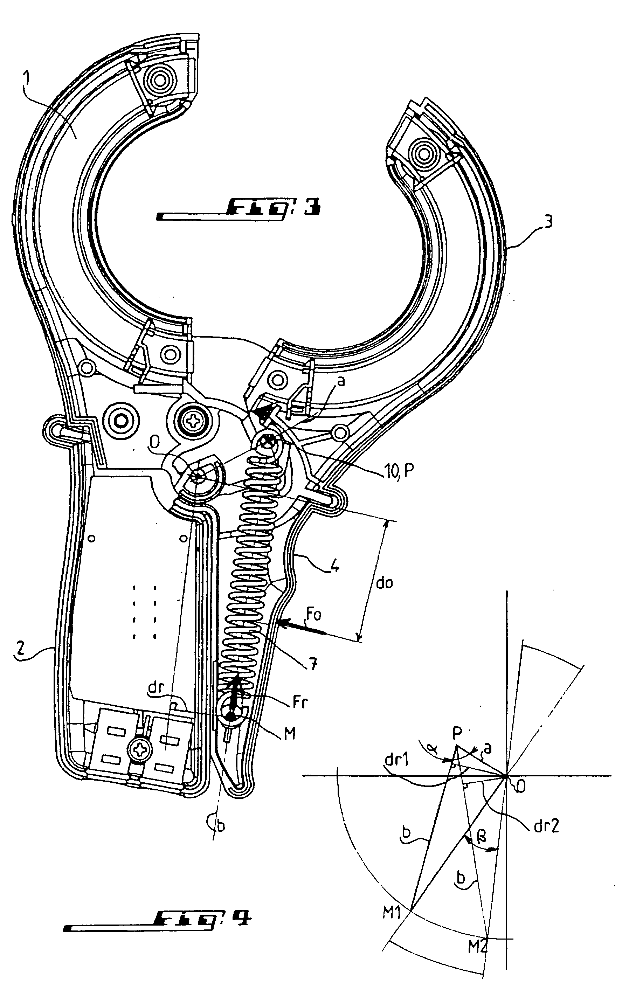

On constate encore que la gâchette est reliée de façon pivotante au boîtier 2, à l'intérieur de celui-ci, en passant à travers une lumière 6 ménagée dans la face formant chant du boîtier 2. Sur les figures 2 et 3, seulement une moitié de la pince est représentée, l'autre étant enlevée pour que l'on puisse voir l'intérieur des deux parties fixe et mobile de chaque moitié de la pince, situées de part et d'autre du plan médian symétrique susmentionné. Etant donné que les autres caractéristiques de la structure générale de la pince ne font pas partie de l'invention, cette structure n'est pas explicitée plus en détail.

La particularité de l'agencement d'ouverture de pince selon l'invention réside dans le fait qu'il comprend un ressort hélicoïdal 7 qui est fixé à une extrémité en M à la gâchette au niveau de l'extrémité libre de celle-ci et à son autre extrémité à une goupille 10 solidaire du boîtier 2 et situé à une certaine distance de l'axe de pivotement 0 à un emplacement P, telle que la ligne droite passant à travers l'axe de pivotement O et l'emplacement P est indiqué en a forme un angle α avec l'axe désigné par b du ressort 7, qui est voisin ou même égal à un angle droit.

Comme il ressort des figures, pour ouvrir la pince, on fait pivoter la gâchette 4 de sa position indiquée sur la figure 2 dans la position illustrée sur la figure 3, en appliquant sur la gâchette une force Fo à l'encontre de la force de rappel du ressort 7, désignée par Fr. Sur les figures, les symboles do et dr indiquent les bras de levier des couples que les forces Fo et Fr exercent autour de l'axe de pivotement O.

En comparant les figures 2 et 3, on constate que le ressort 7 s'allonge, c'est-à-dire sa force de rappel croit quasi linéairement avec l'angle de pivotement β comme cela est indiqué plus clairement sur le schéma de la figure 4 où PM₁ et PM₂ symbolisent le ressort 7 dans les positions de fermeture et d'ouverture de la pince et 0M₁ et 0M₂ symbolisent la gâchette dans les deux cas.

Mais, les figures font aussi apparaître que l'axe du ressort indiqué par les orientations sur la figure 4 de PM₁ et PM₂ se rapproche de l'axe de pivotement O, ce qui signifie que le bras de levier dr diminue de manière significative, comme le montre la comparaison de dr₁ et dr₂.

Par conséquent l'augmentation de la force de rappel Fr est compensée en partie par la diminution du bras de levier dr. Autrement dit, par rapport aux agencements connus dans le cas de l'agencement proposé par l'invention, la force d'ouverture croit moins vite avec l'angle d'ouverture. D'autre part, l'invention présente encore l'avantage de réduire l'encombrement par rapport aux agencements connus. En effet, l'effort nécessaire de fermeture des mâchoires détermine le dimensionnement du ressort. L'invention permet un gain au niveau de l'encombrement en logeant le ressort dans la partie gâchette et non pas dans la partie boîtier, comme dans l'état de la technique. Ceci libère de la place pour la partie électronique dans le boîtier.

Bien entendu, des multiples modifications peuvent être apportées à l'invention telle que décrite en se reportant aux figures, sans sortir du cadre de l'invention. Ainsi il est possible de placer le ressort de rappel non pas dans le levier pivotant, comme cela est représenté, mais entre des emplacements se trouvant sur les leviers au-dessus du point de pivotement O. Sur la figure 2 la ligne en trait mixte indique schématiquement, à titre d'exemple, l'axe du ressort se trouvant dans une position possible telle qu'elle vient d'être évoquée.

## Revendications

1. Agencement d'ouverture d'une pince telle qu'une pince ampèremétrique, du type comprenant une mâchoire de pince fixe (1) portée par un levier fixe (2) et une mâchoire de pince mobile (3) portée par un levier monté pivotant (4) sur le levier fixe, autour d'un axe de pivotement (O) solidaire de ce dernier, entre des positions de fermeture et d'ouverture de la pince, et un ressort de traction de rappel du levier pivotant dans la position de fermeture de la pince, le ressort de traction (7) étant disposé entre un emplacement (P) sur le levier fixe (2) et un emplacement (M) sur le levier pivotant (4), de façon que le ressort s'allonge lors du pivotement du levier (4) de sa position de fermeture de pince dans sa position d'ouverture de pince et que l'axe (b) du ressort de traction, orienté de l'emplacement (P) sur le levier fixe vers l'emplacement (M) sur le levier pivotant, se rapproche de l'axe de pivotement (O) si bien que l'augmentation de la force de rappel (Fr) s'accompagne d'une réduction du bras de levier (dr) de cette force autour de l'axe de pivotement (O) et,
en ce qu'à l'état de fermeture de la pince, l'axe (b) du ressort de traction (7) et l'axe de la force d'ouverture (Fo) à exercer sur le levier mobile pour ouvrir la pince formant un angle sensiblement droit.

2. Agencement selon la revendication 1, **caractérisé en ce que** le ressort (7) avantageusement hélicoïdal est fixé à une extrémité (en M) à la zone d'extrémité libre de levier pivotant (4) et à l'autre extrémité (en P) à un emplacement du levier fixe situé à une distance prédéterminée de l'axe de pivotement du levier pivotant (4), de façon que l'angle (α) entre l'axe du ressort (b) et la ligne droite (a) passant à travers l'axe de pivotement (O) et l'emplacement de fixation (P) du ressort (7) soient approximativement un angle droit.

3. Agencement selon l'une des revendications 1 ou 2, **caractérisé en ce que** le ressort (7) est placé dans le levier mobile (4), sensiblement parallèlement à l'axe de celui-ci.

4. Agencement selon la revendication 1, **caractérisé en ce que** les emplacements de fixation (P, M) du ressort (7) sont situés dans les parties des leviers (2, 4) situées entre l'axe de pivotement (O) et les mâchoires de pince (1, 3).

5. Agencement selon l'une des revendications précédentes, **caractérisé en ce que** le levier pivotant (4) est monté mobile sur le levier fixe (2), à l'intérieur de celui-ci, le ressort (7) étant fixé au levier fixe (2) à l'intérieur (en P) de ce levier.

## Patentansprüche

1. Öffnungsanordnung für eine Zange, wie etwa eine Strommesszange, vom Typ mit einer festen Zangenbacke (1), die von einem festen Hebel (2) getragen wird, und mit einer beweglichen Zangenbacke (3), die von einem Hebel (4) getragen wird, der am festen Hebel um eine fest mit diesem verbundene Schwenkachse (O) zwischen einer Zangenschließstellung und einer Zangenöffnungsstellung verschwenkbar gelagert ist, und mit einer Zugfeder zum Zurückstellen des verschwenkbaren Hebels in die Schließstellung der Zange, wobei die Zugfeder (7) zwischen einer Stelle (P) am festen Hebel (2) und einer Stelle (M) am verschwenkbaren Hebel (4) so angeordnet ist, dass sich die Feder beim Verschwenken des Hebels (4) aus seiner Zangenschließstellung in seine Zangenöffnungsstellung streckt, und dass die Zugfederachse (b), die von der Stelle (P) am festen Hebel zur Stelle (M) am verschwenkbaren Hebel gerichtet ist, sich der Schwenkachse (O) so annährt, dass die Erhöhung der Rückstellkraft (Fr) mit einer Verminderung des Hebelarms (dr) dieser Kraft um die Schwenkachse (O) herum einhergeht, wobei im geschlossenen Zustand der Zange die Achse (b) der Zugfeder (7) und die Achse der zum Öffnen der Zange auf den beweglichen Hebel auszuübenden Öffnungskraft (Fo) im wesentlichen einen rechten Winkel bilden.

2. Anordnung nach Anspruch 1, **dadurch gekennzeichnet, dass** die vorteilhaft schraubenförmig ausgebildete Feder (7) mit einem Ende (bei M) am freien Endbereich des verschwenkbaren Hebels (4) und mit dem anderen Ende (bei P) an einer Stelle des festen Hebels befestigt ist, die in einem vorbestimmten Abstand von der Schwenkachse des verschwenkbaren Hebels (4) liegt, so das der Winkel (α) zwischen Federachse (b) und Geraden (a), die durch die Schwenkachse (O) und die Befestigungsstelle (P) der Feder (7) geht, annährend ein rechter Winkel ist.

3. Anordnung nach einem der Ansprüche 1 oder 2, **dadurch gekennzeichnet, dass** die Feder (7) im beweglichen Hebel (4) im wesentlichen parallel zu dessen Achse eingesetzt ist.

4. Anordnung nach Anspruch 1, **dadurch gekennzeichnet, dass** die Befestigungsstellen (P, M) der Feder (7) sich in denjenigen Bereichen der Hebel (2, 4) befinden, die zwischen der Schwenkachse (O) und den Zangenbacken (1, 3) liegen.

5. Anordnung nach einem der vorangehenden Ansprüche, **dadurch gekennzeichnet, dass** der verschwenkbare Hebel (4) am festen Hebel (2) beweglich gelagert ist, und zwar in dessen Inneren, wobei die Feder (7) am festen Hebel (2) im Inneren (bei P) dieses Hebels befestigt ist.

## Claims

1. Device for opening a clamp such as a current measuring clamp of the type comprising a fixed clamp jaw (1) carried by a fixed lever (2) and a mobile clamp jaw (3) carried by a lever fitted to be pivoting (4) on the fixed lever around a pivoting axis (O), which is integral with it, between the opening and closing positions of the clamp, and an extension spring to recall the pivoting lever into the closing position of the clamp, the extension spring (7) being arranged between a space (P) on the fixed lever and a space (M) on the pivoting lever (4) so that the spring extends during pivoting of the lever (4) from its clamp closing position into its clamp opening position and the axis (b) of the extension spring, which is directed from the space (P) on the fixed lever to the space (M) on the pivoting lever, comes close to the pivoting axis (O) although the increase in the force of recall (Fr) is accompanied by a reduction of the lever arm (dr) by this force around the pivoting axis (O) and in the closing state of the clamp, the axis (b) of the extension spring (7) and the axis of the opening force (Fo) to be exerted on the mobile lever to open the clamp form more or less a right angle.

2. Device according to claim 1, **characterised by** the fact that the spring (7), which is advantageously helical, is fixed at one end (in M) to the free end of the pivoting lever (4) and at the other end (in P) to a space of the fixed lever situated at a predetermined distance from the pivoting axis of the pivoting lever (4) so that the angle (α) between the axis of the spring (b) and the straight line (a) passing through the pivoting axis (O) and the space (P) for fixing the spring (7) are approximately at a right angle.

3. Device according to one of claims 1 or 2, **characterised by** the fact that the spring (7) is placed in the mobile lever (4) more or less parallel to its axis.

4. Device according to claim 1, **characterised by** the fact that the spaces (P, M) for fixing the spring (7) are situated in the parts of the levers (2, 4) situated between the pivoting axis (O) and the clamp jaws (1, 3).

5. Device according to one of the previous claims, **characterised by** the fact that the pivoting lever (4) is fitted to be mobile on the fixed lever (2) inside it, the spring (7) being fixed to the fixed lever (2) inside (in P) this lever.
